# EUROPÄISCHE PATENTANMELDUNG

(11) **EP 4 415 488 A1**
(43) Veröffentlichungstag der Anmeldung: **14.08.2024**
(21) Anmeldenummer: 23155465.0
(22) Anmeldetag: 07.02.2023
(51) Int. Cl.: H05K 1/14, H01M 10/42, H05K 1/11, H05K 1/02

(54) **ADAPTER ZUR KOPPLUNG EINES STEUERRECHNERS, INSBESONDERE EINER ENERGIEMANAGEMENTEINRICHTUNG**

(71) Anmelder: VARTA Microbattery GmbH, 73479 Ellwangen Jagst (DE)
(72) Erfinder: Kloos, Dieter, 74579 Fichtenau (DE)
(74) Vertreter: Ostertag & Partner Patentanwälte mbB

(57) **Zusammenfassung**

Es wird ein Adapter (100; 200) zur Kopplung eines Steuerrechners, insbesondere einer Energiemanagementeinrichtung (30), mit mindestens einem externen Gerät, insbesondere mit einem Wechselrichter (20) und/oder mit einem Batteriespeichersystem (10), bereitgestellt. Der Adapter (100; 200) wird von einer Leiterplatte (110; 210) mit mindestens einer Steckeinrichtung (120; 221, 222) zum Einstecken der Leiterplatte in den Steuerrechner gebildet. Die Leiterplatte (110; 210) umfasst weiterhin mindestens einen Steckverbinder (101, 102), insbesondere einen Randsteckverbinder. Weiterhin weist die Leiterplatte (110; 210) mindestens eine Konfiguration auf, die von einer Leiterstruktur (103) gebildet wird, die die von dem Steuerrechner bereitgestellten Schnittstellen (31, 32, 33) für Kommunikationssignale und/oder Steuerungssignale und/oder Versorgungsspannungen den passenden Pins eines Steckverbinders des externen Geräts zuordnet.

## Beschreibung

Die vorliegende Erfindung betrifft einen Adapter zur Kopplung eines Steuerrechners, insbesondere einer Energiemanagementeinrichtung, mit mindestens einem externen Gerät, insbesondere mit einem Wechselrichter und/oder mit einem Batteriespeichersystem, vorzugsweise einem Hochvolt-Batteriespeichersystem. Weiterhin betrifft die Erfindung eine Steuerrechner, insbesondere eine Energiemanagementeinrichtung, ein Batteriespeichersystem sowie ein Verfahren zum Koppeln eines Steuerrechners mit mindestens einem externen Gerät.

### ANWENDUNGSGEBIET UND STAND DER TECHNIK

Energiespeicher dienen der Speicherung von im Moment verfügbarer, aber nicht benötigter Energie. Besondere Bedeutung haben Hochvolt-Energiespeicher, die beispielsweise im häuslichen Umfeld oder auch im gewerblichen Umfeld im Zusammenhang mit Photovoltaikanlagen oder anderen regenerativen Energiegewinnungsvorrichtungen zum Einsatz kommen und als Zwischenspeicher dienen.

Bei Batteriespeichersystemen auf der Basis von Akkumulatoren (sekundären Energiespeicherelementen) wird die eingespeiste elektrische Energie beim Aufladen des Energiespeichers in chemische Energie umgewandelt. Später kann die so gespeicherte Energie wieder in elektrische Energie umgewandelt und genutzt werden.

Hochvolt-Batteriespeichersysteme umfassen in der Regel eine Vielzahl von einzelnen Energiespeicherzellen, die oftmals in Form von Batteriemodulen zusammengefasst sind. Die Batteriemodule bilden wiederherum einzelne Bausteine für den Aufbau des Hochvolt-Batteriespeichersystem. Ein solches modulares System erlaubt bei der Installation eine flexible Anpassung des Systems an die jeweiligen Erfordernisse und Gegebenheiten.

Um den für das Stromnetz erforderlichen Wechselstrom bereitstellen zu können, müssen Hochvolt-Batteriespeichersysteme in der Regel mit einem Wechselrichter kombiniert werden, um so ein Wechselstrom-Komplettsystem bereitstellen zu können.

Für den Betrieb von Batteriespeichersystemen ist im Allgemeinen ein Steuerrechner und insbesondere eine Energiemanagementeinrichtung erforderlich, um die verschiedenen Parameter bei dem Betrieb des Systems zu steuern und/oder zu regeln. Der Steuerrechner umfasst Komponenten zur elektronischen Datenverarbeitung wie etwa einen Mikroprozessor und/oder einen Datenspeicher. In der Regel ist das Batteriespeichersystem mit elektronischen und/oder sensorischen Bauelemente ausgestattet, um eine Erfassung verschiedener, relevanter Parameter und eine Datenverarbeitung und/oder Datenweiterleitung zu ermöglichen. Die Energiemanagementeinrichtung als bevorzugte Ausführungsform des Steuerrechners regelt den Betrieb des Batteriespeichersystems und dient der Überwachung und Sicherheit des Batteriespeichersystems. Unter anderem kann die Energiemanagementeinrichtung den Batterieladezustand (*State of Charge* - SOC) und den Alterungszustand (*State of Health* - SOH) überwachen und steuern. Die Energiemanagementeinrichtung umfasst daher verschiedene Schnittstellen für Kommunikationssignale und/oder Steuerungssignale und/oder Versorgungsspannungen.

In der Praxis werden bei der Installation einer Anlage mit einem Batteriespeichersystems und insbesondere mit einem Hochvolt-Batteriespeichersystem oftmals Komponenten verschiedener Hersteller miteinander kombiniert. So kann es erforderlich sein, dass eine Energiemanagementeinrichtung während der Installation mit verschiedenen externen Geräten gekoppelt werden muss. Unter externen Geräten sind hierbei insbesondere verschiedene Wechselrichter, die von unterschiedlichen Herstellern stammen können, aber auch verschiedene Hochvolt-Batteriespeichersysteme zu verstehen.

Nicht unproblematisch hierbei ist, dass die verschiedenen, externen Geräte für die vorgesehenen Steckverbindungen unter Umständen gänzlich verschiedene Pin-Belegungen aufweisen und gegebenenfalls mit verschiedenen Bussystemen arbeiten. Zudem besitzt jedes externe Gerät und jedes Batteriespeichersystem in der Regel sein eigenes Datenformat. Für die Installation einer entsprechenden Anlage ist es daher für den Installateur in der Regel erforderlich, die verschiedenen Gegebenheiten der einzelnen Geräte bei der Verbindung und Verschaltung der verschiedenen Komponenten untereinander durch eine in der Regel sehr aufwändige Adaptierung zu berücksichtigen.

Eine mögliche Vorgehensweise zur Adaptierung der Anlage ist, eine spezielle Energiemanagementeinrichtung konkret für die jeweilige Kombination von externen Geräten vorzusehen. Hierfür sind jedoch viele verschiedene Hardwareversionen der Baugruppe für die Energiemanagementeinrichtung erforderlich, und zwar jeweils eine Version für jede Aufbauvariante. Es gibt hierbei also weniger Gleichteile bei der Baugruppe und zudem ist eine aufwändige Zertifizierung der Baugruppen und eine aufwändige Lagerhaltung erforderlich. Weiterhin ist das Endgerät nur schwer umrüstbar, wenn beispielsweise ein Tausch des Wechselrichters oder Ähnliches vorgenommen werden soll. Wenn beispielsweise bei der Montage der Anlage prinzipiell drei verschiedene Wechselrichter und drei verschiedene Batteriespeichersysteme zum Einsatz kommen können, sind insgesamt bereits neun verschiedene Baugruppen für die Energiemanagementeinrichtung nötig.

Eine weitere Möglichkeit für eine Anpassung bei der Montage der Anlage ist eine konfigurierbare, elektronische Schaltmatrix bei der Baugruppe der Energiemanagementeinrichtung. Auch hiermit sind ein hoher Bauteileaufwand und eine aufwändige, schaltungstechnische Umsetzung mit entsprechend hohen Kosten verbunden. Zudem muss der Installateur die Schaltmatrix immer über die Software anpassen, was aufwändig und fehleranfällig ist.

Eine weitere Möglichkeit ist, für jedes mögliche externe Gerät (Peripheriegerät) eine eigene Steckmöglichkeit in der Energiemanagementeinrichtung vorzusehen. Hierfür sind jedoch verhältnismäßig viele Stecker erforderlich. Bei beispielsweise drei möglichen, verschiedenen Wechselrichtern und drei möglichen, verschiedenen Batteriespeichersystemen müssten sechs Stück Stecker, beispielsweise RJ45-Buchsen, vorgesehen sein, die elektrisch alle unterschiedlich sind. Neben dem hierfür erforderlichen hohen Platzverbrauch, den hohen Kosten für die Stecker und dem großen Gehäusedurchbruch, der für die Vielzahl an Buchsen erforderlich ist, birgt diese Vorgehensweise zusätzlich eine große Verwechslungsgefahr, da alle Stecker bzw. Buchsen mechanisch identisch, aber elektrisch unterschiedlich sind. Zudem sind andere externe Geräte, zum Beispiel ein vierter Typ von Wechselrichter, nicht nachträglich integrierbar.

Als weitere Möglichkeit für eine Adaptierung der Schnittstellen ist es grundsätzlich möglich, die erforderliche Funktionalität mit einer Matrix aus DIP-Schaltern zu realisieren. Sollen jedoch sämtliche Signale (beispielsweise 2 x CAN: 4; RS485: 2; Power: 2; Fehlersignale: 2; Wakeup: 1; Sicherheitslinie: 1 → 12 Signale) beliebig mit zwei verschiedenen 8-poligen (16 Pins) RJ45-Buchsen verschaltbar sein, wären beispielsweise 12 x 16 = 192 Schalter nötig. Aus praktischen Gründen ist dies kaum realisierbar bzw. sehr aufwändig.

### AUFGABE UND LÖSUNG

Insgesamt sind die bisherigen Vorgehensweisen für die Installation einer Batteriespeicheranlage mit unterschiedlichen Komponenten sehr aufwendig und unbefriedigend. Vor diesem Hintergrund liegt der vorliegenden Erfindung die Aufgabe zugrunde, eine für den Installateur einfache Kopplung einer Energiemanagementeinrichtung mit externen Geräten, insbesondere mit einem Wechselrichter und gegebenenfalls auch mit dem Hochvolt-Batteriespeichersystem als externem Gerät, zu ermöglichen. Die Installation soll dahingehend vereinfacht werden, dass sie mit wenig Aufwand für unterschiedliche Konstellationen bei der Hardware und mit geringer Fehleranfälligkeit durchgeführt werden kann.

Diese Aufgabe wird durch einen Adapter gelöst, der Gegenstand von Anspruch 1 ist. Bevorzugte Ausgestaltungen des Adapters sind Gegenstand der abhängigen Ansprüche. Weiterhin wird diese Aufgabe durch einen Steuerrechner, insbesondere eine Energiemanagementeinrichtung, und ein Batteriespeichersystem sowie durch ein Verfahren zum Koppeln eines Steuerrechners mit mindestens einem externen Gerät gelöst, wie es sich aus den weiteren nebengeordneten Ansprüchen ergibt.

Der erfindungsgemäße Adapter ist zur Kopplung eines Steuerrechners, insbesondere einer Energiemanagementeinrichtung, mit mindestens einem externen Gerät, insbesondere mit einem Wechselrichter und/oder mit einem Energiespeichersystem, vorgesehen. Insbesondere geht es hierbei um die Kopplung einer Energiespeicheranlage, wobei die Schnittstellen der verschiedenen Komponenten des Systems mit Hilfe des erfindungsgemäßen Adapters in sehr einfacher Weise aneinander angepasst werden können. Der Adapter ist durch die folgenden Merkmale gekennzeichnet:
a. Der Adapter wird von einer Leiterplatte gebildet, die mit mindestens einer Steckeinrichtung zum Einstecken der Leiterplatte in den Steuerrechner, insbesondere in die Energiemanagementeinrichtung, ausgestattet ist.
b. Die Leiterplatte umfasst mindestens einen Steckverbinder, insbesondere einen Randsteckverbinder;
c. Die Leiterplatte weist mindestens eine Konfiguration auf, die von einer Leiterstruktur gebildet wird, die die von dem Steuerrechner, insbesondere der Energiemanagementeinrichtung, bereitgestellten Schnittstellen für Kommunikationssignale und/oder Steuerungssignale und/oder Versorgungsspannungen den passenden Pins eines Steckverbinders des externen Geräts zuordnet.

Bei der Steckeinrichtung der Leiterplatte gemäß dem vorgenannten Merkmal a. handelt es sich insbesondere um einen allgemein bei Leiterplatten üblichen Stecker, mit dem die Leiterplatte in einen Steuerrechner an einen dafür vorgesehenen Steckplatz des Steuerrechners eingesetzt werden kann. Bei der Leiterplatte handelt es sich also um eine steckbare Leiterplatte.

Der Steckverbinder der Leiterplatte, insbesondere der Randsteckverbinder der Leiterplatte, gemäß dem vorgenannten Merkmal b. ist für die Verkabelung mit dem externen Gerät, also insbesondere einem Wechselrichter oder gegebenenfalls auch oder alternativ einem Batteriespeichersystem, insbesondere einem Hochvolt-Batteriespeichersystem, vorgesehen. Bei dem Steckverbinder handelt es sich vorzugsweise um eine Buchse, die mit einem entsprechenden Stecker eines Verbindungskabels des externen Geräts in sehr einfacher Weise verbunden werden kann.

Mit dem erfindungsgemäßen Adapter ist es möglich, dass der Steuerrechner in sehr einfacher Weise an jede mögliche Konfiguration im Hinblick auf externe Geräte und insbesondere im Hinblick auf den jeweiligen Wechselrichter und gegebenenfalls auch (oder alternativ) im Hinblick auf das jeweilige Batteriespeichersystem adaptiert werden kann.

Bei dem Steuerrechner handelt es sich insbesondere um eine Energiemanagementeinrichtung für die zu installierende Anlage. Da je nach Systemkonfiguration unterschiedliche Wechselrichter und unterschiedliche Batteriespeichersysteme vorgesehen sein können, erlaubt der erfindungsgemäße Adapter auf sehr einfache Weise eine Anpassung der Schnittstellen der Energiemanagementeinrichtung an die extern angeschlossenen Geräte. Darüber hinaus kann der erfindungsgemäße Adapter auch bei der Installation von anderen Anlagen zum Einsatz kommen. Die Erfindung stellt also ein System zur Adaptierung und Zuordnung von Datenbussen, Signalen und Versorgungsleitungen bei der Kopplung und Installation eines Steuerrechners bereit.

Bei dem Batteriespeichersystem selbst handelt es sich insbesondere um eine Hochvolt-Batteriespeichersystem. Das Batteriespeichersystem und insbesondere das Hochvolt-Batteriespeichersystem kann vorteilhafterweise ein modulares Batteriespeichersystem sein, das aus mehreren einzelnen Batteriemodulen aufgebaut ist. Die einzelnen Batteriemodule sind jeweils mit einer Mehrzahl von elektrochemischen Energiespeicherelementen, insbesondere sekundären elektrochemischen Energiespeicherelementen, ausgestattet. Derartige Batteriespeichersysteme sind dem Fachmann bekannt.

Physikalisch gesehen handelt es sich bei dem erfindungsgemäßen Adapter um eine steckbare Leiterplatte, die als Konfigurationsmodul in den Steuerrechner und insbesondere in die Energiemanagementeinrichtung gesteckt wird. Der Steuerrechner umfasst daher zweckmäßigerweise einen entsprechenden Steckplatz für die Leiterplatte. Durch die auf der Leiterplatte vorgesehenen Leiterstrukturen werden die von dem Steuerrechner bereitgestellten Schnittstellen, Statussignale, Versorgungsspannungen und Ähnliches den passenden Pins eines Steckverbinders des externen Geräts zugeordnet. Mit dem erfindungsgemäßen Adapter werden also die verschiedenen Schnittstellen zwischen dem Steuerrechner und dem oder den externen Geräten aneinander angepasst.

Die Leiterplatte ist im Hinblick auf das jeweilige externe Gerät entsprechend vorkonfiguriert. Nach Art eines Baukastensystems können für den Installateur unterschiedlich vorkonfigurierte Leiterplatten bereitgestellt werden, die jeweils an ein bestimmtes externes Gerät angepasst sind. Auf diese Weise kann der Installateur die für das jeweils konkret zu installierende externe Gerät geeignete bzw. entsprechend vorkonfigurierte Leiterplatte auswählen und in den Steuerrechner einstecken, so dass anschließend nur noch das entsprechende Verbindungskabel zum Anschließen des externen Geräts eingesteckt werden muss.

Bei dem erfindungsgemäßen Adapter geht es also in erster Linie um eine Anpassung und Verknüpfung (Pinning) der Schnittstellen des Steuerrechner mit externen Geräten, also insbesondere mit einem Wechselrichter, so dass beispielsweise die Installation einer Batteriespeicheranlage mit sehr wenig Aufwand mit unterschiedlich konfigurierten Wechselrichtern durchgeführt werden kann, wobei zur Anpassung der Schnittstellen jeweils nur die entsprechend vorkonfigurierte Leiterplatte als Adapter in die Energiemanagementeinrichtung (Steuerrechner) eingesteckt werden muss.

Weiterhin kann der erfindungsgemäße Adapter auch dahingehend eingesetzt werden, dass unterschiedliche (Hochvolt-)Batteriespeichersysteme, die unterschiedliche Konfigurationen aufweisen, mit einer Energiemanagementeinrichtung über eine Schnittstellenanpassung mittels des erfindungsgemäßen Adapters installiert werden können.

Die Erfindung adressiert also eine universelle Adaptierungsmöglichkeit für verschieden konfigurierte Schnittstellen zwischen einem Steuerrechner und externen Geräten, insbesondere bei der Installation einer Batteriespeicheranlage. Die Leiterplatte, die den erfindungsgemäßen Adapter bildet, ist dabei primär nicht zur Verschaltung der einzelnen Energiespeicherzellen oder der Batteriemodule eines Batteriespeichersystems vorgesehen. Insbesondere umfasst die Leiterplatte des erfindungsgemäßen Adapters in der Regel keinen Hochstromleitungsbereich.

Mit anderen Worten handelt es sich bei dem erfindungsgemäßen Adapter um eine vorkonfigurierte, steckbare Leiterplatte für die Installation eines Steuerrechners und insbesondere einer Energiemanagementeinrichtung, wobei die Leiterplatte eine Anpassung der Schnittstellen zwischen der Energiemanagementeinrichtung als Steuerrechner und externen Geräten erlaubt. Bei den externen Geräten handelt es sich in erster Linie um Wechselrichter, die von unterschiedlichen Herstellern stammen können und die unterschiedlich konfiguriert sein können. Der erfindungsgemäße Adapter erlaubt eine schnelle und einfache Adaption der Schnittstellen der Energiemanagementeinrichtung an das jeweils für die konkret zu installierende Anlage verwendete Gerät. Eine entsprechende Anpassung der Schnittstellen durch einen erfindungsgemäßen Adapter ist auch im Hinblick auf das konkret verwendete Batteriespeichersystem möglich.

Demgemäß zeichnet sich der erfindungsgemäße Adapter durch mindestens eines der folgenden Merkmale aus:
a. Die Leiterplatte weist eine Konfiguration auf, die von einer Leiterstruktur gebildet wird, die die von der Energiemanagementeinrichtung bereitgestellten Schnittstellen für Kommunikationssignale und/oder Steuerungssignale und/oder Versorgungsspannungen den passenden Pins eines Steckverbinders eines Wechselrichters als externem Gerät zuordnet;
b. Die Leiterplatte weist eine Konfiguration auf, die von einer Leiterstruktur gebildet wird, die die von der Energiemanagementeinrichtung bereitgestellten Schnittstellen für Kommunikationssignale und/oder Steuerungssignale und/oder Versorgungsspannungen den passenden Pins eines Steckverbinders eines Batteriespeichersystems, insbesondere eines Hochvolt-Batteriespeichersystems, als externem Gerät zuordnet.

Es kann vorgesehen sein, dass die Leiterplatte entweder eine Konfiguration gemäß dem vorgenannten Merkmal a. oder gemäß dem vorgenannten Merkmal b. aufweist, sodass der Adapter für die Anpassung der Schnittstellen entweder eines Wechselrichters oder eines (Hochvolt-)Batteriespeichersystem vorgesehen ist.

Es kann aber auch vorgesehen sein, dass der Adapter zwei oder gegebenenfalls mehr unterschiedliche Konfigurationen für unterschiedliche Arten von externen Geräten trägt, sodass die Schnittstellen von unterschiedlichen externen Geräten mit einem und demselben Adapter angepasst werden können. Gemäß einer Kombination der vorgenannten Merkmale a. und b. kann somit ein einzelner Adapter beispielsweise für die Anpassung der Schnittstellen für eine bestimmte Kombination eines konkreten Hochvolt-Batteriespeichersystems mit einem konkreten Wechselrichter vorkonfiguriert werden.

Im Hinblick auf das zu installierende (Hochvolt-)Batteriespeichersystem kann es jedoch auch vorgesehen sein, dass die Energiemanagementeinrichtung mit dem eigentlichen Batteriespeichersystem nicht über den erfindungsgemäßen Adapter, sondern auf andere Weise verbunden und verschaltet ist. Dies ist insbesondere in solchen Fällen zweckmäßig, in denen die Energiemanagementeinrichtung und das Batteriespeichersystem von dem gleichen Hersteller stammen und in der Regel in Kombination miteinander installiert werden. In diesen Fällen kann es vorgesehen sein, dass der erfindungsgemäße Adapter nur für weitere externe Geräte, also insbesondere für den konkret verwendeten Wechselrichter, der von einem anderen Hersteller stammen kann, verwendet wird.

In einer weiteren, besonders bevorzugt vorgesehenen Ausführungsform des erfindungsgemäßen Adapters zeichnet sich der Adapter durch das folgende zusätzliche Merkmal aus:
a. Die Leiterplatte umfasst mindestens einen Code, insbesondere einen festverdrahteten Code, der die Systemkonfiguration des mindestens einen externen Geräts, insbesondere die Systemkonfiguration eines Wechselrichters oder eines (Hochvolt- )Batteriespeichersystems, kodiert.

In dieser besonders bevorzugten Ausführungsform umfasst die Leiterplatte, die den Adapter bildet, eine Systemcodierung, so dass der Steuerrechner während der Installation das jeweilige externe Gerät automatisch erkennt. In dieser Ausführungsform erfüllt der erfindungsgemäße Adapter also zum einen die Funktion einer Schnittstellenkonfiguration und zum anderen die Funktion einer Systemerkennung für die Software des Steuerrechners.

Darüber hinaus bietet diese Ausführungsform den besonderen Vorteil, dass ein falsch gewählter Adapter, der nicht die richtige Vorkonfiguration für das jeweilige Gerät trägt, automatisch erkannt werden und der Fehler behoben werden kann.

Bei der kodierten Systemkonfiguration handelt es sich zweckmäßigerweise um die Konfiguration desjenigen Systems bzw. desjenigen Geräts, dessen Schnittstellen mit dem erfindungsgemäßen Adapter angepasst werden sollen.

Wenn der erfindungsgemäße Adapter für eine Adaptierung und Anpassung der Schnittstellen sowohl für einen bestimmten Wechselrichter als auch für ein bestimmtes (Hochvolt- )Batteriespeichersystem vorgesehen ist, ist es besonders bevorzugt, dass der jeweilige Adapter sowohl eine Codierung für die Systemkonfiguration des jeweiligen Wechselrichters als auch eine Codierung für die Systemkonfiguration des jeweiligen Batteriespeichersystems umfasst.

In besonders bevorzugten Ausgestaltungen des erfindungsgemäßen Adapters ist das folgende zusätzliche Merkmal vorgesehen:
a. Der oder die Steckverbinder der Leiterplatte, insbesondere die Randsteckverbinder, sind standardisierte Steckverbinder, insbesondere RJ45-Steckverbinder.

Die Ausbildung der Steckverbinder der Leiterplatte als standardisierte Steckverbinder und insbesondere als RJ45-Steckverbinder (RJ - *Registered Jack*) ist besonders vorteilhaft, da in der Regel die Steckverbinder der externen Geräte, also insbesondere eines Wechselrichters, ebenfalls standardisierte Steckverbinder sind. Bevorzugterweise handelt es sich bei dem Steckverbinder der Leiterplatte um eine Steckverbinderbuchse. Insbesondere RJ45-Steckverbinder sind derart verbreitet, dass eine entsprechend ausgebildete Leiterplatte als Adapter mit entsprechender Vorkonfiguration nahezu universell für die auf dem Markt befindlichen Geräte einsetzbar ist. Der entsprechend vorkonfigurierte, erfindungsgemäße Adapter kann daher für eine Schnittstellenanpassung bei der Montage von Batteriespeicheranlagen mit im Prinzip allen möglichen denkbaren Kombinationen von auf dem Markt verfügbaren Geräten eingesetzt werden.

Die Leiterplatte, die den erfindungsgemäßen Adapter bildet, kann auch als Adapterplatine bezeichnet werden. Diese Adapterplatine ist vorzugsweise als doppelseitige Leiterplatte mit Randsteckverbinder ausgebildet. Es kann sich dabei um eine vergleichsweise kleine und steckbare Leiterplatte handeln.

Die steckbare Leiterplatte kann ausschließlich mit den Leiterbahnen versehen sein, die die Verbindungen zur Schnittstellenanpassung herstellen. Im Übrigen kann die Leiterplatte unbestückt sein. Darüber hinaus können die Leiterbahnen in der oben beschriebenen Weise vorzugsweise einen Systemcode darbieten, der die Systemkonfiguration des jeweiligen externen Geräts repräsentiert.

Es ist beispielsweise möglich, dass als Leiterplatte eine an sich bekannte Randsteckverbinderkarte vom Typ PCI-E 64 verwendet wird, die in Anpassung an das jeweilige externe Gerät entsprechend vorkonfiguriert ist. Eine Leiterplatte dieses Typs ist wegen des massenhaften Einsatzes in modernen PCs ausgesprochen kostengünstig. Zusätzlich ist eine solche Karte bzw. ein solcher Slotstecker trotz seiner Vielzahl an Pins ausgesprochen kompakt.

Da für die Verbindung und Zuordnung der Schnittstellen nicht alle Pins einer PCI-E 64-Steckverbinderkarte benötigt werden, sind noch genügend Pins verfügbar, um einen Systemcode darzustellen, anhand dessen der Steuerrechner erkennen kann, wie das entsprechende externe Gerät, für das die Karte vorgesehen ist, und das System konfiguriert sind. Für diese Codierung können beispielsweise die jeweiligen Pins wahlweise auf +Vcc (hohe Spannung) oder GND (niedrige Spannung) gelegt werden, um Einsen und Nullen zu repräsentieren. Es können auch Pins freigelassen werden, wodurch eine trinäre Kodierung möglich ist (Eins, Null, hochohmig). Somit wären bei beispielsweise zehn Pins bei einer binären Codierung 2¹⁰ = 1024 unterschiedliche Konfigurationen kodierbar. Bei einer trinären Codierung wären es entsprechend 3¹⁰ = 59.049 Möglichkeiten. Die Pins oder Bits einer solchen Steckkarte, die als Leiterplatte für den erfindungsgemäßen Adapter verwendet werden kann, können neben der Verbindung und Zuordnung der Schnittstellen also auch für die Kodierung einer bestimmten Hardware-Version des jeweiligen externen Geräts verwendet werden.

In weiteren bevorzugten Ausgestaltungen des erfindungsgemäßen Adapters ist mindestens eines der folgenden zusätzlichen Merkmale vorgesehen:
a. Die Leiterplatte umfasst ein weiteres Terminal, insbesondere eine Klemmen- oder Stiftleiste, zur Anbindung und/oder Zuordnung von zusätzlichen Signalen;
b. Die Leiterplatte ist mit weiteren Komponenten bestückt.

Vorzugsweise sind die vorgenannten Merkmale a. und b. in Kombination miteinander realisiert, so dass der erfindungsgemäße Adapter verschiedene zusätzliche Funktionalitäten bereitstellen kann. Damit kann auch eine bestehende Anlage nachträglich um weitere Eigenschaften und Schnittstellen erweitert und ergänzt werden.

Insbesondere kann die Leiterplatte zusätzliche Bauteile tragen, um die Leistungs- und Steuerelektronik einer Batteriespeicheranlage zu erweitern.

In weiteren Ausgestaltungen können analog zur Funktion eines Dongles durch eine entsprechende Konfiguration der Leiterplatte auch gewisse Features der Anlage, insbesondere des Batteriespeichersystems, beispielsweise freigeschaltet oder gesperrt werden.

Im Hinblick auf die Anzahl der Konfigurationen kann der erfindungsgemäße Adapter in verschiedener Weise ausgebildet sein. So ist es zunächst möglich, dass die Leiterplatte mit einer einzelnen Konfiguration versehen ist, so dass der Adapter im Hinblick auf ein bestimmtes externes Gerät zur Verbindung und Zuordnung von dessen Schnittstellen ausgebildet ist. Darüber hinaus ist es auch möglich, dass die Leiterplatte für zwei oder gegebenenfalls mehr verschiedene externe Geräte vorkonfiguriert ist. So ist in einer besonders bevorzugten Ausführungsform des erfindungsgemäßen Adapters mindestens eines der folgenden zusätzlichen Merkmale realisiert:
a. Die Leiterplatte weist zwei unterschiedliche Konfigurationen auf, die jeweils von einer Leiterstruktur gebildet werden, die die von dem Steuerrechner bereitgestellten Schnittstellen für Kommunikationssignale und/oder Steuerungssignale und/oder Versorgungsspannungen den passenden Pins eines Steckverbinders eines jeweiligen externen Geräts zuordnet;
b. Die Leiterplatte umfasst zwei Steckeinrichtungen zum Einstecken der Leiterplatte in den Steuerrechner, wobei die Steckeinrichtungen jeweils einer der Konfigurationen auf der Leiterplatte zugeordnet sind;
c. Die zwei Steckeinrichtungen liegen auf einander gegenüberliegenden Seiten der Leiterplatte;
d. Die Leiterplatte umfasst einen ersten Code, insbesondere einen festverdrahteten Code, der die Systemkonfiguration eines ersten externen Geräts kodiert, und einen zweiten Code, insbesondere einen festverdrahteten Code, der die Systemkonfiguration eines zweiten externen Geräts kodiert.

Vorzugsweise sind die vorgenannten Merkmale a. und b. und, besonders bevorzugt, die vorgenannten Merkmale a. und b. und c, und ganz besonders bevorzugt, die vorgenannten Merkmale a. bis d. in Kombination miteinander realisiert.

In dieser Ausführungsform handelt es sich gewissermaßen um eine "dual"-Version des Adapters, wobei die Leiterplatte zwei unterschiedliche Leiterstrukturen aufweist, die zwei unterschiedliche Konfigurationen für zwei verschiedene externe Geräte, beispielsweise für zwei verschiedene Wechselrichter von unterschiedlichen Herstellern, abbilden. Je nachdem, welches externe Gerät bzw. welcher Wechselrichter in der konkreten Anlage eingebaut werden soll, wird die Leiterplatte entsprechend in den Steckplatz des Steuerrechners, also insbesondere der Energiemanagementeinrichtung, eingesteckt.

Auf diese Weise kann ein- und derselbe Adapter für die Anpassung der Schnittstellen von zwei unterschiedlichen externen Geräten genutzt werden. Je nachdem, wie die Leiterplatte gesteckt wird, kommt dabei die eine oder die andere der beiden unterschiedlichen Konfigurationen zum Tragen. In dieser Ausgestaltung des erfindungsgemäßen Adapters kann die Leiterplatte entweder mit der einen oder mit der anderen Seite in den Steckplatz des Steuerrechners eingeschoben werden, so dass die entsprechende Konfiguration für das konkret zu installierende externe Gerät angeschlossen wird. In dieser Ausführungsform ist der erfindungsgemäße Adapter also durch unterschiedliches Stecken für verschiedene externe Geräte, je nach Bedarf, verwendbar.

In weiteren bevorzugten Ausführungsformen des erfindungsgemäßen Adapters ist es auch möglich, mehr als zwei unterschiedliche Konfigurationen auf einer einzelnen Leiterplatte zu kombinieren. Demgemäß ist der erfindungsgemäße Adapter in bevorzugten Ausgestaltungen durch mindestens eines der folgenden zusätzlichen Merkmale gekennzeichnet:
a. Die Leiterplatte weist drei oder vier unterschiedliche Konfigurationen auf, die jeweils von einer Leiterstruktur gebildet werden, die die von dem Steuerrechner bereitgestellten Schnittstellen für Kommunikationssignale und/oder Steuerungssignale und/oder Versorgungsspannungen den passenden Pins eines Steckverbinders eines jeweiligen externen Geräts zuordnet;
b. Die Leiterplatte umfasst drei oder vier Steckeinrichtungen zum Einstecken der Leiterplatte in den Steuerrechner, wobei die Steckeinrichtungen jeweils einer der Konfigurationen auf der Leiterplatte zugeordnet sind.
c. Die Leiterplatte (210) umfasst einen ersten Code, insbesondere einen festverdrahteten Code, der die Systemkonfiguration eines ersten externen Geräts kodiert, und einen zweiten Code, insbesondere einen festverdrahteten Code, der die Systemkonfiguration eines zweiten externen Geräts kodiert, und einen dritten Code, insbesondere einen festverdrahteten Code, der die Systemkonfiguration eines dritten externen Geräts kodiert, und gegebenenfalls einen vierten Code, insbesondere einen festverdrahteten Code, der die Systemkonfiguration eines vierten externen Geräts kodiert.

Vorzugsweise sind die vorgenannten Merkmale a. und b., und besonders bevorzugt, die vorgenannten Merkmale a. und b. und c. in Kombination miteinander realisiert.

In diesen Ausgestaltungen handelt es sich bei dem Adapter also gewissermaßen um eine "Triple"- oder "Quad"-Version mit drei oder vier unterschiedlichen Konfigurationen und einer entsprechenden Anzahl an Steckeinrichtungen zum Einstecken der Leiterplatte in den Steckplatz des Steuerrechners. Die Steckeinrichtungen befinden sich vorzugweise an den verschiedenen Seiten der Leiterplatte. Je nachdem, mit welcher Steckeinrichtung die Leiterplatte in den Steckplatz gesteckt wird, kommt die jeweilige Konfiguration zum Tragen.

Bei den externen Geräten, für die der Adapter vorkonfiguriert ist, handelt es sich vorzugsweise um verschiedene Wechselrichter, beispielsweise um Wechselrichter unterschiedlicher Hersteller.

Von der Erfindung umfasst ist auch ein Set von verschiedenen Leiterplatten bzw. von verschiedenen erfindungsgemäßen Adaptern für unterschiedliche externe Geräte, die für den Installateur bei der Installation einer entsprechenden Anlage zur Verfügung stehen. Je nach den konkret verwendeten Komponenten für eine bestimmte Anlage kann der Installateur den geeigneten Adapter bzw. die entsprechend vorkonfigurierte Leiterplatte auswählen und für die Installation verwenden. Dieses Set umfasst demgemäß eine Mehrzahl von verschiedenen Adaptern gemäß der obigen Beschreibung, wobei die Adapter jeweils unterschiedliche Konfigurationen zur Zuordnung der Schnittstellen eines Steuerrechners und insbesondere einer Energiemanagementeinrichtung zu den passenden Pins von Steckverbindern unterschiedlicher externer Geräte, insbesondere unterschiedlicher Wechselrichter, aufweisen.

Die Erfindung umfasst weiterhin einen Steuerrechner und insbesondere eine Energiemanagementeinrichtung, der bzw. die sich dadurch auszeichnet, dass er bzw. sie mit mindestens einen Adapter gemäß der obigen Beschreibung ausgestattet ist, wobei dieser Adapter zum Koppeln des Steuerrechners mit mindestens einem externen Gerät, insbesondere mit einem Wechselrichter und/oder einem (Hochvolt-)Batteriespeichersystem, vorgesehen ist. Bezüglich weiterer Merkmale dieses Steuerrechners und dieses Adapters wird auf die obige Beschreibung verwiesen.

Weiterhin umfasst die Erfindung ein Batteriespeichersystem und insbesondere eine Hochvolt-Batteriespeichersystem, mit einer Energiemanagementeinrichtung (Steuerrechner). Auch hier zeichnet sich die Energiemanagementeinrichtung dadurch aus, dass sie mit mindestens einem Adapter gemäß der obigen Beschreibung zum Koppeln der Energiemanagementeinrichtung mit einem externen Gerät, insbesondere mit einem Wechselrichter, ausgestattet ist.

Das (Hochvolt-)Batteriespeichersystem umfasst weiterhin in an sich bekannter Weise eine Mehrzahl von elektrochemischen Energiespeicherelementen, die zum Zwischenspeichern von elektrischer Energie geeignet sind. Vorzugsweise handelt es sich bei dem Batteriespeichersystem um ein modulares System, das aus mehreren Batteriemodulen aufgebaut ist, wobei die einzelnen Batteriemodule jeweils eine Mehrzahl von elektrochemischen Energiespeicherelementen in an sich bekannter Weise umfassen. Bei den Energiespeicherelementen kann es sich insbesondere um zylindrische Rundzellen handeln, vorzugsweise um Lithium-lonen-Zellen. Zweckmäßigerweise handelt es sich hierbei um sekundäre, also wiederaufladbare, Lithium-lonen-Zellen.

In einem Batteriemodul können die einzelnen elektrochemischen Zellen in einzelnen Batterieblöcken zusammengeschaltet sein. Beispielsweise können zylindrische Rundzellen oder auch prismatische Zellen als elektrochemische Zellen verwendet werden, die in einem Batterieblock derart angeordnet sein, dass deren Längsachsen parallel zueinander liegen.

Beispielsweise können die Zellen innerhalb des Batterieblocks in einem regelmäßigen Muster in einer Ebene angeordnet sein. Besonders bevorzugt sind zylindrische Rundzellen, da die zwangsläufig zwischen den Zellen entstehenden Hohlräume eine gute Temperierung erlauben. Zwei oder mehr derartiger Batterieblöcke können in einem Batteriemodul innerhalb eines Gehäuses zusammengefasst werden und damit eine Einheit bilden. Die Batteriemodule bilden dann die Bausteine für ein Batteriesystem. Ein modulares Batteriespeichersystem hat den besonderen Vorteil, dass bei der Installation der Anlage eine flexible Anpassung und Dimensionierung des Systems an die jeweiligen Erfordernisse und Gegebenheiten durch Auswahl einer entsprechenden Anzahl der Module möglich ist.

Bezüglich weiterer Merkmale dieses Batteriespeichersystems und dieser Energiemanagementeinrichtung und dieses Adapters wird auf die obige Beschreibung verwiesen.

Darüber hinaus umfasst die Erfindung auch eine (Hochvolt-)Batteriespeicheranlage, die eine Energiemanagementeinrichtung mit mindestens einem erfindungsgemäßen Adapter, ein (Hochvolt-)Batteriespeichersystem in der oben beschriebenen Weise und mindestens einen Wechselrichter umfasst. Hierbei handelt es sich insbesondere um ein Wechselstrom-Komplettsystem.

Schließlich umfasst die Erfindung ein Verfahren zum Koppeln eines Steuerrechners, insbesondere einer Energiemanagementeinrichtung, mit mindestens einem externen Gerät, insbesondere mit einem Wechselrichter und/oder mit einem (Hochvolt- )Batteriespeichersystem. Bei diesem Verfahren wird ein Adapter gemäß der obigen Beschreibung in einen Steckplatz des Steuerrechners gesteckt und eine Verbindung, insbesondere eine Kabelverbindung, zwischen einem Steckverbinder des Adapters und dem mindestens einen externen Gerät hergestellt. Dieses Verfahren erlaubt beispielsweise bei der Installation einer Batteriespeicheranlage eine für den Installateur sehr einfache Schnittstellenanpassung zwischen der Energiemanagementeinrichtung und dem oder den externen Geräten über die erfindungsgemäße, entsprechend vorkonfigurierte steckbare Leiterplatte. Bezüglich weiterer Merkmale dieses Verfahrens wird auch auf die obige Beschreibung verwiesen.

Der besondere Vorteil der Erfindung liegt darin, dass der erfindungsgemäße Adapter eine sehr einfache Kopplung und Schnittstellenanpassung bei der Montage einer Anlage mit einem Steuerrechner erlaubt. Nach der mechanischen Installation der Anlage, insbesondere einer (Hochvolt-)Batteriespeicheranlage, beim Endkunden schließt der Installateur beispielsweise zunächst die Datenverbindungen mit Standard-Patchkabeln an und steckt dann den für die jeweilige Anlage passenden Adapter in den Steuerrechner bzw. in die Energiemanagementeinrichtung. Die Schnittstellen für die externen Geräte sind damit fertig konfiguriert und die Software des Steuerrechners, insbesondere der Energiemanagementeinrichtung, ist darüber informiert, was für ein externes Gerät, beispielsweise welcher Wechselrichter, angeschlossen ist.

Der erfindungsgemäße Adapter erlaubt darüber hinaus eine sehr kostengünstige Lösung des Problems der Schnittstellenanpassung. Bei den Steckkarten für die erfindungsgemäßen Adapter kann auf Massenprodukte zurückgegriffen werden, wobei lediglich eine entsprechende Konfigurierung der Steckkarten in Anpassung an die Schnittstellen bei den jeweiligen Geräten vorzunehmen ist. Der Installateur kann sich daher in sehr kostengünstiger Weise verschiedene, vorkonfigurierte Adapter bereitlegen, die beispielsweise für verschiedene Wechselrichter-Versionen bei der Montage einer Batteriespeicheranlage eingesetzt werden können. Für besonders bevorzugte Konfigurationen können auch jedem ausgelieferten Steuerrechner, insbesondere jeder ausgelieferten Energiemanagementeinrichtung, bzw. jedem ausgelieferten Batteriespeichersystem solche Adapter bereits beigelegt werden.

Den Herstellern von Batteriespeichersystemen und von Energiemanagementeinrichtungen bzw. von Steuerrechnern allgemein erlaubt die Erfindung darüber hinaus den besonderen Vorteil, dass stets die gleichen Produkte ausgeliefert werden können. Es ist keine Lagerhaltung verschiedener Produktvarianten erforderlich, wobei dennoch eine Anpassung in der Endanwendung im Hinblick auf verschiedene externe Geräte, insbesondere eine Anpassung an verschiedene Wechselrichter unterschiedlicher Hersteller, in einfacher Weise durch das Stecken des entsprechend vorkonfigurierten Adapters möglich ist.

Schließlich bietet die Erfindung eine erhebliche Fehlersicherheit. Der einzige Fehler in der Konfiguration, der vom Installateur noch gemacht werden kann, ist das Stecken eines falschen Adapters. Dies kann in einfacher Weise beispielsweise durch eine deutliche Beschriftung des Adapters verhindert werden. Zudem wird bei der bevorzugten Ausgestaltung des Adapters mit einer Systemcodierung dieser Fehler während der Montage im Zuge der Systemerkennung durch die Software des Steuerrechners rechtzeitig erkannt, so dass ein solcher Fehler schnell behoben werden kann.

Die Vorteile des erfindungsgemäßen Adapters können insbesondere bei der Montage von Heim-Energiespeicheranlagen genutzt werden. Prinzipiell ist das System mit dem erfindungsgemäßen Adapter auch bei anderen Arten von Geräten und Anlagen anwendbar. Allgemein ist der erfindungsgemäße Adapter für eine flexible und einfach durchzuführende Schnittstellenanpassung von verschiedenen Komponenten einer Anlage sehr gut geeignet.

Weitere Merkmale und Vorteile der Erfindung ergeben sich aus der nachfolgenden Beschreibung von bevorzugten Ausführungsbeispielen in Verbindung mit den Zeichnungen. Hierbei können die einzelnen Merkmale jeweils für sich oder in Kombination miteinander realisiert sein.

In den Figuren zeigen:
- Fig. 1: schematische Schaltzeichnung zu einer installierten Hochvolt-Batteriespeicheranlage mit Verwendung eines erfindungsgemäßen Adapters;
- Fig. 2: Beispiel für eine auf einem erfindungsgemäßen Adapter kodierte Systemkonfiguration;
- Fig. 3: Darstellung einer ersten Ausführungsbeispiels eines erfindungsgemäßen Adapters separat (A) und in eingebautem Zustand (B); und
- Fig. 4: Darstellung eines weiteren Ausführungsbeispiels eines erfindungsgemäßen Adapters separat (A) und in eingebautem Zustand (B).

### Beschreibung von Ausführungsbeispielen

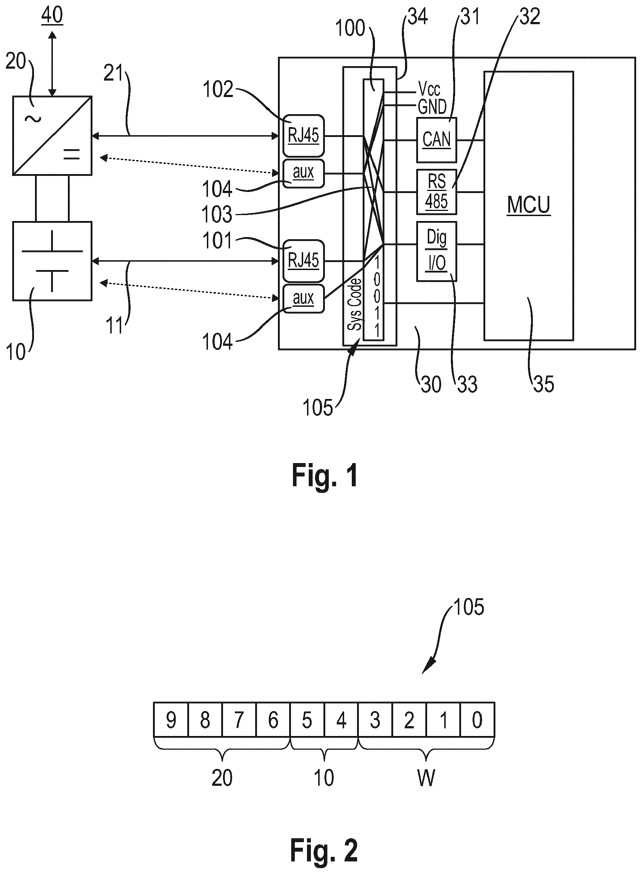

**Fig. 1** illustriert in schematischer Weise den Aufbau einer Hochvolt-Batteriespeicheranlage mit einem Hochvolt-Batteriespeichersystem 10, einem Wechselrichter 20 und einer Energiemanagementeinrichtung 30, bei der es sich um den Steuerrechner für die gesamte Anlage handelt. Der in dem Batteriespeichersystem 10 speicherbare und abgebbare Gleichstrom wird über den Wechselrichter 20 in Wechselstrom umgewandelt, so dass er für das Stromnetz 40 bereitgestellt werden kann. Dies gilt sowohl für das Entladen des Batteriespeichersystems 10 als auch entsprechend für das Laden des Batteriespeichersystems 10. Die Steuerung, Kommunikation und Versorgung des Batteriespeichersystems 10 und des Wechselrichters 20 erfolgen über die Energiemanagementeinrichtung 30. Hierfür sind entsprechende Verkabelungen 11 und 21 zwischen dem Batteriespeichersystem 10 bzw. dem Wechselrichter 20 und der Energiemanagementeinrichtung 30 vorgesehen.

Zur Adaptierung der verschiedenen Schnittstellen 31, 32, 33, die hier beispielhaft dargestellt sind, an die entsprechenden Schnittstellen der externen Geräte, also insbesondere des Batteriespeichersystems 10 und des Wechselrichters 20, ist ein erfindungsgemäßer Adapter 100 in einen entsprechenden Steckplatz 34 der Energiemanagementeinrichtung 30 eingesetzt. Der Adapter 100 wird erfindungsgemäß von einer entsprechend vorkonfigurierten Leiterplatte gebildet, die dafür sorgt, dass eine korrekte Pin-Belegung bei den Steckverbindungen 101, 102 und damit bei der Verkabelung mit den externen Geräten 10 und 20 erfolgt. Diese Adaptierung der Schnittstellen über den erfindungsgemäßen Adapter 100 erfolgt in diesem Ausführungsbeispiel sowohl für das Batteriespeichersystem 10 als auch für den Wechselrichter 20. In anderen Ausführungsbeispielen kann es vorgesehen sein, dass die Verschaltung der Energiemanagementeinrichtung mit dem Batteriespeichersystem auf andere Weise erfolgt und nur ein Wechselrichter oder gegebenenfalls andere externe Geräte über den erfindungsgemäßen Adapter in Bezug auf ihre Schnittstellen angepasst werden.

Bei den Steckverbindern 101 und 102 des Adapters 100 handelt es sich vorzugsweise um genormte bzw. standardisierte Steckverbinder. Besonders bevorzugt sind hierbei die sehr weit verbreiteten RJ45-Steckverbinder. In diesem Ausführungsbeispiel stellt der Adapter 100 zwei Randsteckverbinder in Form von RJ45-Steckverbinderbuchsen bereit. Die externen Geräte, also das Batteriespeichersystem 10 und der Wechselrichter 20, weisen ebenfalls RJ45-Steckverbinder bzw. entsprechende Anschlussmöglichkeiten auf, so dass ohne weitere Anpassungen eine einfache Verkabelung möglich ist.

Die Anpassung der Schnittstellen erfolgt über eine entsprechend vorkonfigurierte Leiterstruktur 103 auf der den Adapter 100 bildenden Leiterplatte. Durch diese Leiterstruktur 103 werden die hier beispielhaft gezeigten Schnittstellen 31, 32 und 33 der Energiemanagementeinrichtung 30 den passenden Pins der Steckverbinder der externen Geräte, also in diesem Ausführungsbeispiel dem Hochvolt-Batteriespeichersystem 10 und dem Wechselrichter 20, zugeordnet, so dass eine Kommunikation zwischen dem Prozessor 35, beispielsweise einen Mikroprozessor, und den externen Geräten und eine entsprechende Steuerung der externen Geräte möglich ist.

Zusätzlich kann mittels des Adapters 100 auch die Verschaltung mit weiteren Signalaus- und - eingängen 104 (aux) angepasst werden.

Darüber hinaus ist auf dem erfindungsgemäßen Adapter 100 eine Kodierung der Systemkonfiguration, also der Konfiguration der zu verschaltenden externen Geräte, in Form eines fest verdrahteten Codes 105 vorgesehen. **Fig. 2** zeigt eine beispielhafte Belegung der Pins einer PCI-E 64-Steckverbinderkarte, die als erfindungsgemäßer Adapter 100 verwendet werden kann. In diesem Ausführungsbeispiel der Kodierung 105 kodieren die Pins 9, 8, 7 und 6 den verwendeten Wechselrichter 20, die Pins 5 und 4 das verwendete Hochvolt-Batteriespeichersystem 10 und die Pins 3, 2, 1 und 0 die verwendete Hardware-Version (HW) und gegebenenfalls weitere Features des Systems. Anhand dieser Kodierung kann die Software der Energiemanagementeinrichtung 30 erkennen, wie das gesamte System konfiguriert ist und welche einzelnen Komponenten anzuschließen sind. Für diese Kodierung werden die jeweiligen Pins insbesondere wahlweise auf +Vcc oder GND gelegt, um somit einen binären Code zu repräsentieren. In anderen Ausführungsformen kann auch ein trinärer Code (Eins, Null, hochohmig) hiermit dargestellt werden.

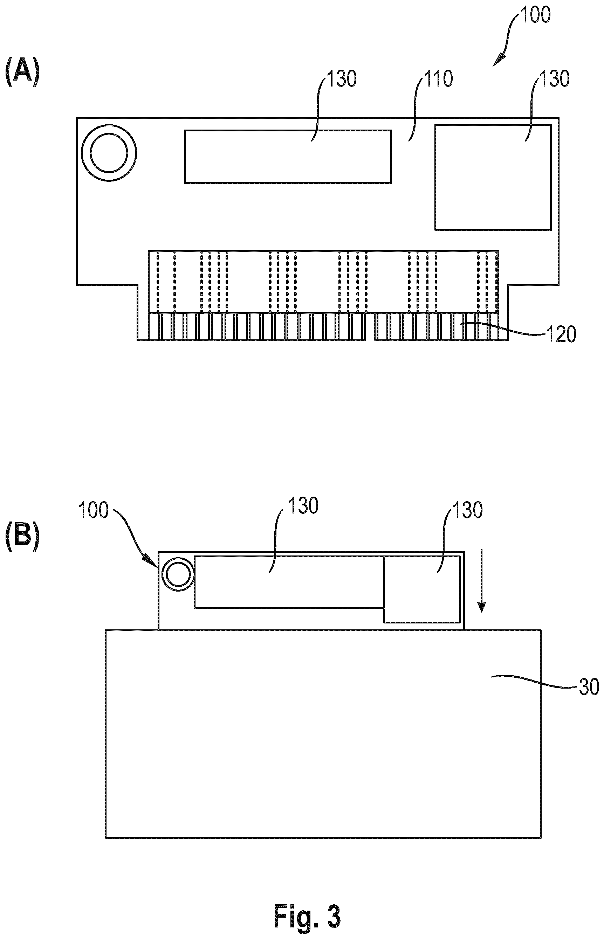

**Fig. 3** zeigt eine beispielhafte Ausgestaltung eines erfindungsgemäßen Adapters 100 in Form einer Leiterplatte 110, die an einer Längsseite mit einer Steckeinrichtung 120 versehen ist, über die der Adapter 100 in einen entsprechenden Steckplatz einer Energiemanagementeinrichtung 30 oder allgemein eines Steuerrechners einbaubar ist (Plug-in). Fig. 3A zeigt die separate Leiterplatte 110 und Fig. 3B zeigt den eingebauten Zustand der Leiterplatte bzw. des Adapters 100 in der Energiemanagementeinrichtung 30. Die Leiterplatte ist weiterhin mit einem oder mehreren hier nicht näher dargestellten Steckverbindern, insbesondere Randsteckverbindern, ausgestattet, die direkt an der Leiterplatte angefügt sein können oder über entsprechende Kabelverbindungen an die Leiterplatte 110 angeschlossen werden können. Insbesondere handelt es sich hierbei um RJ45-Steckverbinderbuchsen.

Über entsprechende, hier nicht näher dargestellte Leiterstrukturen ist der Adapter 100 für eine Schnittstellenanpassung zwischen einem externen Gerät und der Energiemanagementeinrichtung 30 in der oben beschriebenen Weise vorkonfiguriert.

Die hier dargestellte Ausführungsform eines Adapters 100 ist mit zwei Beschriftungsfeldern 130 versehen, die verschiedene Informationen für den Anwender in schriftlicher Form enthalten können, insbesondere Angaben zu der Systemkonfiguration und zu den Bezeichnungen des externen Geräts, dessen Verschaltung hiermit adaptiert werden soll, z.B. eine Seriennummer oder ähnliches.

Weiterhin ist in der Darstellung der Fig. 3A links oben ein kreisförmiges Loch vorgesehen, sodass mehrere solcher Adapter mit einem Ring oder ähnlichem zu einer Art Bund zusammengefasst werden können und für den Installateur in handlicher Weise zur Verfügung stehen. Der Installateur hat dann die verschiedenen möglichen Konfigurationen gewissermaßen auf der Hand und kann mit wenigen Handgriffen den für die jeweilige Anlage richtigen Adapter auswählen und einbauen. Zusätzlich kann ein solches Loch als Hilfe beim Herausziehen des Adapters aus dem Steckplatz eines Steuerrechners dienen.

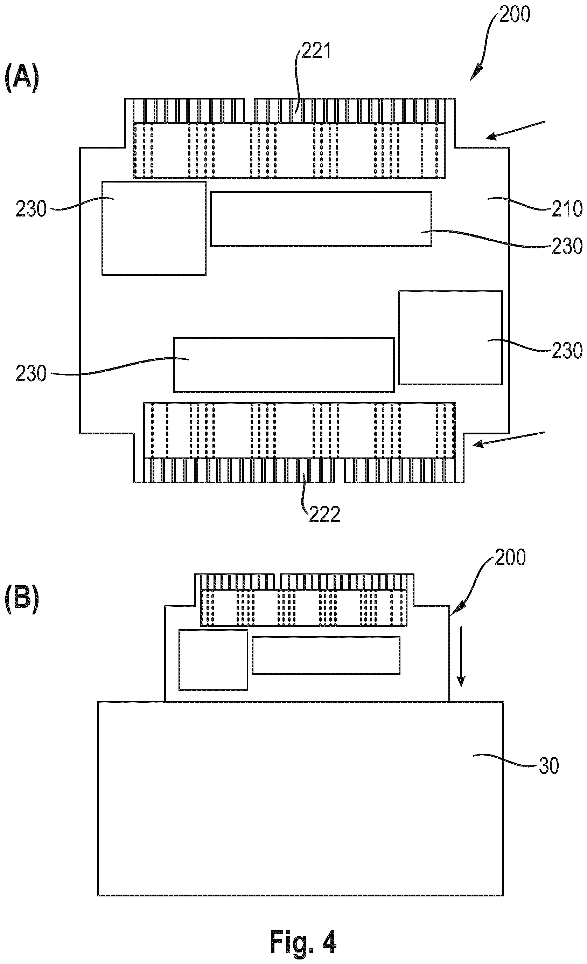

**Fig. 4** illustriert eine duale Version eines Adapters 200, bei der zwei unterschiedliche Leiterstruktur-Konfigurationen auf der Leiterplatte 210 vorgesehen sind. Fig. 4A zeigt die separate Leiterplatte 210 und Fig. 4B zeigt den eingebauten Zustand der Leiterplatte bzw. des Adapters 200 in der Energiemanagementeinrichtung 30. Ein solcher Adapter 200 kann für die Anpassung der Schnittstellen für zwei unterschiedliche externe Geräten wahlweise genutzt werden. Zu diesem Zweck umfasst der Adapter 200 zwei Steckeinrichtungen 221, 222 auf einander gegenüberliegenden Längsseiten der Leiterplatte 210. Wenn die Leiterplatte 210 über die Steckeinrichtung 221 in den Steckplatz einer Energiemanagementeinrichtung 30 eingesetzt wird, kommen diejenigen Leiterstrukturen des Adapters 200 zum Tragen, die die Schnittstellen für ein erstes externes Gerät anpassen. Wird der Adapter 200 über die Steckeinrichtung 222 in den Steckplatz der Energiemanagementeinrichtung 30 eingebaut, kommen diejenigen Leiterstrukturen auf der Leiterplatte 210 zum Tragen, die die Schnittstellen für ein anderes externes Gerät anpassen. Je nach den verwendeten externen Geräten, also beispielsweise einem Wechselrichter des Herstellers A oder einem Wechselrichter des Herstellers B, kann die Leiterplatte 210 mit der einen oder der anderen Seite in den Steckplatz der Energiemanagementeinrichtung 30 eingeschoben werden, um so die Schnittstellen richtig zu verbinden.

Zweckmäßigerweise trägt der Adapter 200 entsprechende Beschriftungsfelder 230, um die erforderlichen Angaben und Informationen für den Installateur bereitzustellen, so dass das richtige Einstecken des Adapters 200 bzw. die Wahl der richtigen Seite des Adapters 200 gewährleistet wird.

Für die Kopplung einer Batteriespeicheranlage stehen dem Installateur zweckmäßigerweise verschiedene erfindungsgemäße Adapter zur Verfügung, die jeweils für unterschiedliche externe Geräte vorkonfiguriert sind. Auf diese Weise kann der Installateur in Anpassung an die jeweils zu installierenden externen Geräte den jeweils richtigen Adapter (und/oder gegebenenfalls die richtige Adapterseite) auswählen und in den Steckplatz der Energiemanagementeinrichtung einbauen.

Der erfindungsgemäße Adapter erlaubt eine Anpassung der verschiedenen Hardwarekomponenten einer Anlage durch das Stecken einer einzigen, kleinen und sehr kostengünstigen Leiterplatte bzw. Steckkarte. Darüber hinaus bietet sich hiermit eine universelle Lösung für das Problem einer Schnittstellenanpassung bei der Kopplung von verschiedenen Geräten. Diese Schnittstellenanpassung ist auch für spätere Anpassungen bei einer bereits installierten Anlage geeignet.

## Patentansprüche

1. Adapter (100; 200) für die Kopplung eines Steuerrechners mit mindestens einem externen Gerät, durch die folgenden Merkmale gekennzeichnet:
a. Der Adapter (100; 200) wird von einer Leiterplatte (110; 210) mit mindestens einer Steckeinrichtung (120; 221, 222) zum Einstecken der Leiterplatte in den Steuerrechner gebildet;
b. Die Leiterplatte (110; 210) umfasst mindestens einen Steckverbinder (101, 102), insbesondere einen Randsteckverbinder;
c. Die Leiterplatte (110; 210) weist mindestens eine Konfiguration auf, die von einer Leiterstruktur (103) gebildet wird, die die von dem Steuerrechner bereitgestellten Schnittstellen (31, 32, 33) für Kommunikationssignale und/oder Steuerungssignale und/oder Versorgungsspannungen den passenden Pins eines Steckverbinders des externen Geräts zuordnet.

2. Adapter nach Anspruch 1 mit mindestens einem der folgenden zusätzlichen Merkmale:
a. Der Steuerrechner ist eine Energiemanagementeinrichtung (30);
b. Das mindestens eine externe Gerät ist ein Wechselrichter (20) und/oder ein Batteriespeichersystem (10).

3. Adapter nach Anspruch 2 mit mindestens einem der folgenden zusätzlichen Merkmale:
a. Die Leiterplatte (110; 210) weist eine Konfiguration auf, die von einer Leiterstruktur (103) gebildet wird, die die von der Energiemanagementeinrichtung (30) bereitgestellten Schnittstellen (31, 32, 33) für Kommunikationssignale und/oder Steuerungssignale und/oder Versorgungsspannungen den passenden Pins eines Steckverbinders eines Wechselrichters (20) als externem Gerät zuordnet;
b. Die Leiterplatte (110; 210) weist eine Konfiguration auf, die von einer Leiterstruktur (103) gebildet wird, die die von der Energiemanagementeinrichtung (30) bereitgestellten Schnittstellen (31, 32, 33) für Kommunikationssignale und/oder Steuerungssignale und/oder Versorgungsspannungen den passenden Pins eines Steckverbinders eines Batteriespeichersystems (10), insbesondere eines Hochvolt-Batteriespeichersystems, als externem Gerät zuordnet.

4. Adapter nach einem der vorhergehenden Ansprüche mit dem folgenden zusätzlichen Merkmal:
a. Die Leiterplatte (110; 210) umfasst mindestens einen Code (105), insbesondere einen festverdrahteten Code, der die Systemkonfiguration des mindestens einen externen Geräts kodiert.

5. Adapter nach einem der vorhergehenden Ansprüche mit dem folgenden zusätzlichen Merkmal:
a. Der oder die Steckverbinder (102, 103) der Leiterplatte, insbesondere die Randsteckverbinder, sind standardisierte Steckverbinder, insbesondere RJ45-Steckverbinder.

6. Adapter nach einem der vorhergehenden Ansprüche mit mindestens einem der folgenden zusätzlichen Merkmale:
a. Die Leiterplatte (110; 210) umfasst ein weiteres Terminal, insbesondere eine Klemmen- oder Stiftleiste, zur Anbindung und/oder Zuordnung von zusätzlichen Signalen;
b. Die Leiterplatte ist mit weiteren Komponenten bestückt.

7. Adapter nach einem der vorhergehenden Ansprüche mit mindestens einem der folgenden zusätzlichen Merkmale:
a. Die Leiterplatte (210) weist zwei unterschiedliche Konfigurationen auf, die jeweils von einer Leiterstruktur gebildet werden, die die von dem Steuerrechner bereitgestellten Schnittstellen (31, 32, 33) für Kommunikationssignale und/oder Steuerungssignale und/oder Versorgungsspannungen den passenden Pins eines Steckverbinders eines jeweiligen externen Geräts zuordnet;
b. Die Leiterplatte (210) umfasst zwei Steckeinrichtungen (221, 222) zum Einstecken der Leiterplatte in den Steuerrechner, wobei die Steckeinrichtungen jeweils einer der Konfigurationen auf der Leiterplatte zugeordnet sind;
c. Die zwei Steckeinrichtungen (221, 222) liegen auf einander gegenüberliegenden Seiten der Leiterplatte (210);
d. Die Leiterplatte (210) umfasst einen ersten Code, insbesondere einen festverdrahteten Code, der die Systemkonfiguration eines ersten externen Geräts kodiert, und einen zweiten Code, insbesondere einen festverdrahteten Code, der die Systemkonfiguration eines zweiten externen Geräts kodiert.

8. Adapter nach einem der vorhergehenden Ansprüche mit mindestens einem der folgenden zusätzlichen Merkmale:
a. Die Leiterplatte weist drei oder vier unterschiedliche Konfigurationen auf, die jeweils von einer Leiterstruktur gebildet werden, die die von dem Steuerrechner bereitgestellten Schnittstellen (31, 32, 33) für Kommunikationssignale und/oder Steuerungssignale und/oder Versorgungsspannungen den passenden Pins eines Steckverbinders eines jeweiligen externen Geräts zuordnet;
b. Die Leiterplatte umfasst drei oder vier Steckeinrichtungen zum Einstecken der Leiterplatte in Steuerrechner, wobei die Steckeinrichtungen jeweils einer der Konfigurationen auf der Leiterplatte zugeordnet sind;
c. Die Leiterplatte umfasst einen ersten Code, insbesondere einen festverdrahteten Code, der die Systemkonfiguration eines ersten externen Geräts kodiert, und einen zweiten Code, insbesondere einen festverdrahteten Code, der die Systemkonfiguration eines zweiten externen Geräts kodiert, und einen dritten Code, insbesondere einen festverdrahteten Code, der die Systemkonfiguration eines dritten externen Geräts kodiert, und gegebenenfalls einen vierten Code, insbesondere einen festverdrahteten Code, der die Systemkonfiguration eines vierten externen Geräts kodiert.

9. Adapter nach Anspruch 7 oder Anspruch 8 mit dem folgenden zusätzlichen Merkmal:
a. Die externen Geräte sind unterschiedliche Wechselrichter.

10. Set mit einer Mehrzahl von verschiedenen Adaptern (100; 200) gemäß einem der Ansprüche 1 bis 9, **dadurch gekennzeichnet, dass** die Adapter jeweils unterschiedliche Konfigurationen zur Zuordnung der Schnittstellen eines Steuerrechners, insbesondere einer Energiemanagementeinrichtung, zu den passenden Pins von Steckverbindern unterschiedlicher externer Geräte, insbesondere unterschiedlicher Wechselrichter, aufweisen.

11. Steuerrechner, insbesondere Energiemanagementeinrichtung (30), **dadurch gekennzeichnet, dass** der Steuerrechner mit mindestens einem Adapter (100; 200) gemäß einem der Ansprüche 1 bis 9 zum Koppeln des Steuerrechners mit mindestens einem externen Gerät, insbesondere mit einem Wechselrichter (20) und/oder einem Batteriespeichersystem (10), insbesondere einem Hochvolt-Batteriespeichersystem, ausgestattet ist.

12. Batteriespeichersystem (10), insbesondere Hochvolt-Batteriespeichersystem, mit einer Energiemanagementeinrichtung (30), **dadurch gekennzeichnet, dass** die Energiemanagementeinrichtung (30) mit mindestens einem Adapter (100; 200) gemäß einem der Ansprüche 1 bis 9 zum Koppeln der Energiemanagementeinrichtung (30) mit einem externen Gerät, insbesondere mit einem Wechselrichter (20), ausgestattet ist.

13. Verfahren zum Koppeln eines Steuerrechners, insbesondere einer Energiemanagementeinrichtung (30), mit mindestens einem externen Gerät, insbesondere mit einem Wechselrichter (20) und/oder einem Batteriespeichersystem (10), **dadurch gekennzeichnet, dass** ein Adapter (100; 200) gemäß einem der Ansprüche 1 bis 9 in einen Steckplatz (34) des Steuerrechners gesteckt und eine Verbindung, insbesondere eine Kabelverbindung, zwischen einem Steckverbinder des Adapters (100; 200) und dem mindestens einen externen Gerät hergestellt wird.
